# EUROPEAN PATENT APPLICATION

(11) **EP 4 539 113 A1**
(43) Date of publication of application: **16.04.2025**
(21) Application number: 24203722.4
(22) Date of filing: 30.09.2024
(51) Int. Cl.: H01L 21/673

(54) **WAFER BOAT SYSTEM**

(30) Priority: 03.10.2023 US 202363542169 P
(71) Applicant: ASM IP Holding B.V., 1322 AP Almere (NL)
(72) Inventor: BOONSTRA, Klaas P., 1322 AP Almere (NL); OOSTERLAKEN, Theodorus G.M., 1322 AP Almere (NL); VAN DEN BRINK, Bram, 1322 AP Almere (NL); SPRUIT, Anne Geertruid Maria, 1322 AP Almere (NL)
(74) Representative: V.O.

(57) **Abstract**

A wafer boat system comprising: a carrier extending along a carrier axis and comprising a first end member at a first axial end of the carrier, a second end member at a second axial end of the carrier, and a shell connecting the first end member with the second end member, wherein at least three circumferentially spaced apart axial series of ring support slots are provided to the shell, the ring support slots defining axially spaced apart holder ring positions; and a plurality of holder rings each engageable with the ring support slots to position the holder ring in the carrier at one of the holder ring positions, wherein the holder ring is configured to support a wafer in the carrier, wherein the shell circumferentially interconnects the axial series of slots, wherein axial series of gas transmission openings are formed in the shell between the axial series of slots.

## Description

### FIELD OF INVENTION

The invention relates to a wafer boat system comprising a carrier and a plurality of holder rings. The invention further relates to such a carrier, to such a holder ring, and to a combination of the wafer boat system and an apparatus constructed and arranged to process a plurality of substrates.

### BACKGROUND OF THE DISCLOSURE

Wafer boats are known as such for use in processing semiconductor wafers in batches, for example for vapor deposition on the wafers. A wafer boat is typically a mainly cylindrical structure in which a number of circular wafers can be received axially spaced apart. The cylinder axis of the wafer boat may be oriented vertically so that the wafers extend mainly horizontally.

US 6,287,112 B1 explains the general problem of possible non-uniformity across the wafer surface when a treatment gas is supplied radially. In particular, so-called edge effects may occur, e.g. resulting in increased material deposition at the edge of the wafer compared to at the center of the wafer. US 6,287,112 B1 also discusses the possible use of rings to increase the uniformity. In some variations, the wafers may be supported on such rings, so that the rings may be regarded as holder rings.

Although past developments have contributed to increased uniformity of deposition across the wafer surface, further improvements are still desired. Meanwhile, it is desired for wafer processing to be efficient.

### SUMMARY OF THE DISCLOSURE

With an aim to improving uniformity of deposition across wafer surfaces while maintaining or improving wafer processing efficiency, an aspect of the present invention provides a wafer boat system.

The wafer boat system comprises a carrier extending along a carrier axis and comprising a first end member at a first axial end of the carrier, a second end member at a second axial end of the carrier, and a shell connecting the first end member with the second end member, wherein at least three circumferentially spaced apart axial series of ring support slots are provided to the shell, the ring support slots defining axially spaced apart holder ring positions.

The wafer boat system comprises a plurality of holder rings each engageable with the ring support slots to position the holder ring in the carrier at one of the holder ring positions, wherein the holder ring is configured to support a wafer in the carrier.

The shell circumferentially interconnects the axial series of slots, wherein axial series of gas transmission openings are formed in the shell between the axial series of slots.

Advantageously, the shell can obviate the need for rods as found in traditional wafer boat designs such as in US 6,287,112 B1, and can thereby facilitate greater uniformity of deposition. In this respect, it is considered that the traditional rods typically resulted in non-uniformities, in particular due to the rods during use being present relatively locally along the wafer circumference and being arranged relatively close to the wafer's edge in radial direction. By contrast, the effect of the shell on the deposition can be more distributed along the circumference and can be reduced overall due to a possible greater radial distance of the shell to the wafer, in particular compared to the radial distance of the traditional rods to the wafer.

Meanwhile, it has been found that structural performance, e.g. stiffness and/or strength, of the carrier having the shell can be essentially maintained or improved compared to the traditional carrier design with rods. Without wishing to be bound by theory, it is considered that the maintained or improved structural performance may be in particular associated with the shell circumferentially interconnecting the different axial series of slots, allowing the axial series of slots to derive stability and strength from each other via the shell, in particular at many axial positions between the first and second end members. The gas transmission openings in the shell facilitate movement of process gas towards the wafer while still allowing the shell to circumferentially interconnect the axial series of slots. During use, holder rings with wafers supported thereon can be moved into or out of the carrier for example automatically, thereby facilitating efficiency. Thereto, the shell may allow transverse access into the carrier, in particular between two of the axial series of slots, as explained further elsewhere herein.

Further aspects provide: a carrier evidently configured for use as the carrier of a wafer boat system as described herein; and a holder ring evidently configured for use as one of the holder rings of a wafer boat system as described herein. Advantages of such a carrier and such a holder ring correspond to those described above for the wafer boat system, in particular in the sense that such or a similar wafer boat system can be formed using such a carrier and/or such holder rings.

A still further aspect provides a combination of a wafer boat system as described herein and an apparatus constructed and arranged to process a plurality of substrates. The apparatus comprises: a process tube creating a process chamber; and a door configured to close off the process chamber while supporting the wafer boat system with a plurality of substrates therein. Such a combination advantageously allows the wafer boat system to be used for processing semiconductor wafers in batches, for example for vapor deposition on the wafers as substrates. In this way, the described advantages of improved uniformity can be utilized, in particular relatively efficiently. Advantageously, the apparatus may be of a type known as such, so that the advantages of the wafer boat system can be utilized without necessarily requiring adaptation of the apparatus. Thereto, for example, outer dimensions of the carrier of the present wafer boat system may substantially correspond to outer dimensions of a known carrier for use in such an apparatus.

Optional advantageous elaborations of the above aspects are provided by the subject-matter of the dependent claims, as explained further in the below detailed description.

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE DRAWING FIGURES

In the following, the invention will be explained further using examples of embodiments and drawings. The drawings are schematic and merely show an example. In the drawings, corresponding elements are provided with corresponding reference signs. For clarity of the drawings, reference signs for some elements may be omitted in some figures where the presence of those elements is otherwise apparent, e.g. from the same or similar elements being provided with reference signs in the same or similar figures. Although reference will be made to the drawings showing an example, the description of embodiments herein may also be understood independent from the drawings, and it shall be appreciated that described embodiments may variously be applied with or without combination with one or more other embodiments.

In the drawings:
Fig. 1 shows a perspective view of a carrier without holder rings;
Fig. 2 shows a perspective view of the carrier of Fig. 1 with holder rings;
Fig. 3 shows a perspective view of one of the holder rings;
Figs. 4 and 5 show a cross sectional perspective view, respectively a cross sectional top view, of the carrier with holder rings of Fig. 2, in particular showing an axial section of the carrier with holder rings including the second end member; and
Fig. 6 shows a highly schematic cross sectional side view of an apparatus with a wafer boat system.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below

The illustrations presented herein are not meant to be actual views of any particular material, structure, or device, but are merely idealized representations that are used to describe embodiments of the disclosure.

The particular implementations shown and described are illustrative of the invention and its best mode and are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present disclosure includes all novel and nonobvious combinations and subcombinations of the various processes, systems, and configurations, and other features, functions, acts, and/or properties disclosed herein, as well as any and all equivalents.

The figures illustrate a wafer boat system 1 comprising a carrier 2 and a plurality of holder rings 7. The carrier 2 extends along a carrier axis C and comprises a first end member 3a at a first axial end of the carrier 2, a second end member 3b at a second axial end of the carrier 2, and a shell 4 connecting the first end member 3a with the second end member 3b.

The carrier 2 may have a substantially cylindrical shape, wherein the first and second end members 3a, 3b define substantially circular end faces of the substantially cylindrical shape, and wherein the carrier axis C corresponds to a cylinder axis of the substantially cylindrical shape. Nevertheless, as explained further elsewhere herein, it shall be appreciated that various openings may be provided in or to the carrier 2 so that the carrier 2 need not form a complete cylinder. Support legs may extend from a bottom side of the second end member 3b. The carrier 2 may be made from a material known as such for wafer boats, for example being made from quartz glass, also known as fused quartz or fused silica.

At least three circumferentially spaced apart axial series 5a, 5b, 5c of ring support slots 6 are provided to the shell 4, the ring support slots 6 defining axially spaced apart holder ring positions. Preferably, the ring support slots 6 may be formed as openings or recesses in the shell 4. Alternatively or additionally, one or more of the ring support slots may be formed between protrusions extending radially inwardly from the shell 4.

The holder rings 7 are each engageable with the ring support slots 6 to position the holder ring 7 in the carrier 2 at one of the holder ring positions. Thereto, as explained further elsewhere herein, at circumferential positions S corresponding to the ring support slots 6, an outer diameter RO of the holder ring 7 may be relatively large, e.g. being locally equal to a largest outer diameter ROmax of the holder ring 7. The design of the slots 6 and the portions of the holder ring 7 intended to engage the slots 6 preferably takes into account a transverse direction T in which the holder rings 7 may be moved into or out of the carrier 2. For a relatively secure engagement of the holder ring 7 with the slots 6, one or more mutually engageable retaining structures such as ridges and/or grooves may be provided to the holder ring 7 and one or more of the respective slots 6, the retaining structures when mutually engaged being arranged to resist accidental transverse movement of the holder ring 7 out of the carrier 2 while still allowing intentional movement of the holder ring 7 out of the carrier 2, e.g. by slightly lifting the holder ring 7 with respect to the carrier 2 to thereby disengage the retaining structures.

The holder ring 7 is configured to support a wafer 8 in the carrier 2, at least when the holder ring 7 is positioned in the carrier 2. In this way, the wafer 8 may be supported in the carrier 2 without direct contact between the wafer and the carrier 2.

The shell 4 circumferentially interconnects the axial series of slots 5a, 5b, 5c. In particular, interconnecting parts of the shell 4 provide force transmission between the axial series of slots 5a, 5b, 5c along the circumferential direction as defined relative to the carrier axis C, thereby allowing mutual reinforcement between the different axial series of slots 5a, 5b, 5c via the shell 4. The circumferential interconnection of the axial series of slots 5a, 5b, 5c by the shell 4 is preferably substantially distributed across an axial range corresponding to axial ranges of the axial series of slots 5a, 5b, 5c.

Axial series 9a, 9b of gas transmission openings 10 are formed in the shell 4 between the axial series of slots 5a, 5b, 5c. Preferably, such gas transmission openings 10 are formed as elongate openings extending mainly circumferentially with a relatively small axial dimension or width. The circumferential interconnection of the axial series of slots 5a, 5b, 5c by the shell 4 can then be realized relatively effectively between the gas transmission openings 10, in particular by arcuate narrow beam-like sections of the shell 4, while still allowing a relatively large total surface area of the gas transmission openings 10. Accordingly, the gas transmission openings 10 preferably extend along relatively large circumferential sections of the shell 4 between the axial series of slots 5a, 5b, 5c, e.g. corresponding to at least 80% or at least 90% of the circumferential distances between the axial series of slots 5a, 5b, 5c.

In embodiments, the shell 4 is circumferentially bound at two outer ones 5a, 5b of the axial series of slots to allow holder rings 7 and wafers 8 to be moved into or out from the carrier 2 between the two outer axial series of slots 5a, 5b in a transverse direction T with respect to the carrier 2.

In this way, such movement of holder rings 7 and wafers 8 can be substantially unobstructed by the shell 4, in particular while the shell 4 can still circumferentially interconnect the axial series of slots 5a, 5b, 5c. In particular, the outer ones 5a, 5b of the axial series of slots may thus be interconnected by the shell 4 via a further or inner one 5c of the axial series of slots. In this respect, it shall be appreciated that axial series of slots 5a, 5b may be referred to as outer ones, as opposed to the inner one 5c, essentially on account of their circumferential positions with respect to the shell 4, whereas each of the axial series of slots 5a, 5b, 5c may still be at mutually equal radial positions with respect to the carrier axis C.

In embodiments, the two outer axial series of slots 5a, 5b are formed as toothed edges of the shell 4, each toothed edge having an axial series of teeth 11 with interdental spaces 12 between the teeth 11, wherein the interdental spaces 12 form the respective slots 6.

In this way, the two outer axial series of slots 5a, 5b can be formed particularly effectively, allowing engagement of the holder rings 7 as well as transverse movement of the holder rings 7 into or out of the carrier 2. Meanwhile, the engagement between the holder rings 7 and the outer axial series of slots 5a, 5b can still be relatively well spaced apart from the wafer 8.

In embodiments, each of the holder rings 7 has an annular body 13. In particular, the holder ring 7 may be substantially formed by the annular body 13, apart from optional ring projections 14 explained elsewhere herein. The annular body 13 may be formed as a flat disc, e.g. having a thickness similar to a thickness of the wafer 8, thereby being relatively compact in terms of axial dimensions and thus allowing transmission of gas between the holder rings 7 while still allowing a relatively large number of holder rings 7 in the carrier 2.

In embodiments, an outer radius RO of the holder ring 7, in particular of the annular body 13, varies along its circumference between a largest outer radius ROmax and a smallest outer radius ROmin. Various advantages can be obtained by such a variable outer radius RO, as is explained further elsewhere herein. In a general sense, such a variable outer radius RO allows to take potential effects of the carrier 2 on the deposition uniformity into account, in particular in a compensatory manner that promotes a high level of deposition uniformity, while also taking structural and space constraints into account. In this respect, without wishing to be bound by theory, it is considered that effect of surrounding structures such as holder rings and the carrier on uniformity of deposition on the wafer may at least partly depend on local surface area of those structures as well as on distances between those structures and the edge of the wafer 8. Thus, for a relatively uniform deposition, in particular in terms of a radial direction, it is preferred that surface are of such structures is relatively small and/or relatively far away from the wafer 8. At the same time, to promote uniformity in a circumferential direction, it is preferred that the combined local effect of the surrounding structures on the deposition is similar all along the circumference of the wafer 8.

In embodiments, the outer radius RO is smaller than the largest outer radius ROmax, and preferably larger than the smallest outer radius ROmin, at circumferential positions G corresponding to the gas transmission openings 10 when the holder ring 7 is engaged with the ring support slots 6. Since the gas transmission openings 10 extend in the shell 4, and the shell 4 interconnects the axial series of slots 5a, 5b, 5c, some material of the shell 4 is present at these positions G, potentially having an effect on deposition uniformity. By the outer radius RO being smaller than the largest outer radius ROmax at these positions G, the rings 7 can essentially provide at least partial compensation of the local potential effect from the shell 4. Meanwhile, when the outer radius RO at these positions G is larger than the smallest outer radius ROmin, the compensatory effect can be relatively well measured, in particular being relatively moderate compared to a possible larger effect at the positions S of the slots 6, as explained elsewhere herein.

In embodiments, the outer radius RO is larger than the smallest outer radius ROmin, and preferably smaller than or equal to the largest outer radius ROmax, at circumferential positions F that are not radially adjacent the shell 4 when the holder ring 7 is engaged with the ring support slots 6. In this way, the effect of the holder rings 7 on the deposition uniformity can be larger at positions F where the shell 4 does not have an effect on the deposition uniformity. Thus, a combined effect of the shell 4 and the holder rings 7 on local deposition uniformity can be about the same all along the circumference of the wafer 8. When the outer radius RO at the positions F is smaller than the largest outer radius ROmax, the outer radius RO at these positions F can still be relatively well moderated.

In embodiments, the outer radius RO at the circumferential positions F that are not radially adjacent the shell 4 is larger than the outer radius RO at the circumferential positions G corresponding to the gas transmission openings 10. In this way, a particularly uniform deposition can be promoted, essentially because the surface area of the holder ring 7 at said circumferential positions F can thus be similar to the combined surface area of the holder ring 7 and the gas transmission openings 10 at said circumferential positions G.

In embodiments, the largest outer radius ROmax is present at circumferential positions S corresponding to the ring support slots 6 to allow the holder ring 7, in particular the annular body 13, to extend into and/or engage the ring support slots 6. A relatively stable and secure engagement can be obtained in this way, in particular without necessarily requiring a large local surface area of the carrier 2 and/or the holder rings 7 close to the wafer 8. In other words, the engagement between holder rings 7 and carrier 2 can be relatively well spaced apart from the wafer 8, thereby promoting a relatively high level of deposition uniformity.

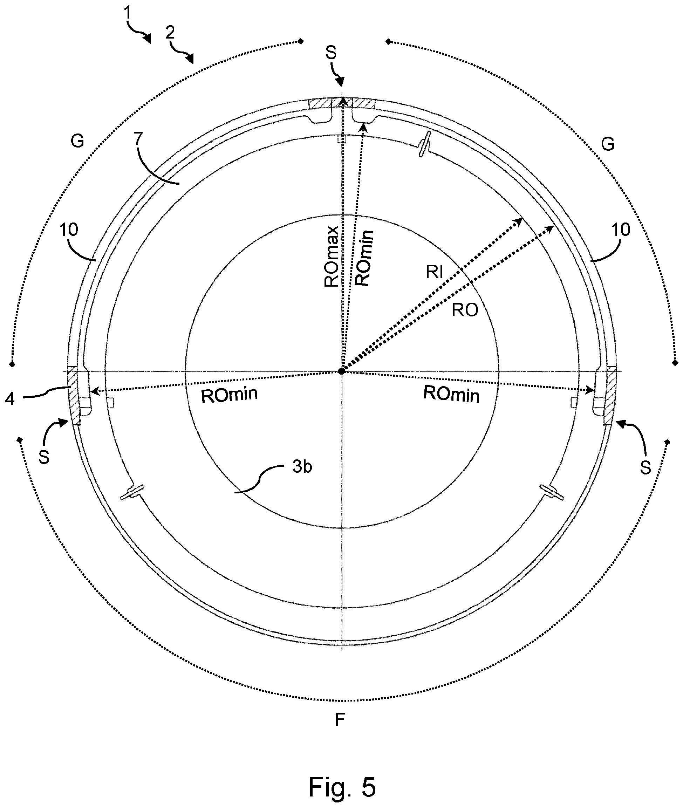

In embodiments, the smallest outer radius ROmin is present adjacent circumferential positions S corresponding to one or more of the ring support slots 6, in particular at circumferential positions that are circumferentially between one or more of the ring support slots 6 and adjacent ones of the gas transmission openings 10. In this way, a particularly uniform deposition can be promoted, essentially because the smallest outer radius ROmin present between the ring support slots 6 and the gas transmission openings 10, resulting in a locally reduced surface area of the holder ring 7, can at least partly compensate for a local absence of gas transmission through the shell 4. Although in Fig. 5 as an example it is indicated that the smallest outer radius ROmin is present at each of the three positions S, it shall be appreciated that alternatively the smallest outer radius ROmin may be present at only one or some of these positions S, whereas at other such positions the local outer radius RO may for example be slightly larger than the smallest outer radius ROmin.

In embodiments, the gas transmission openings 10 are arranged axially between the holder ring positions, i.e. between where the holder rings 7 may be positioned as defined by the ring support slots 6. In this way, the gas transmission openings 10 may be axially aligned with the wafers 8 on the holder rings 7, thereby promoting a relatively free movement of gas to the wafers 8.

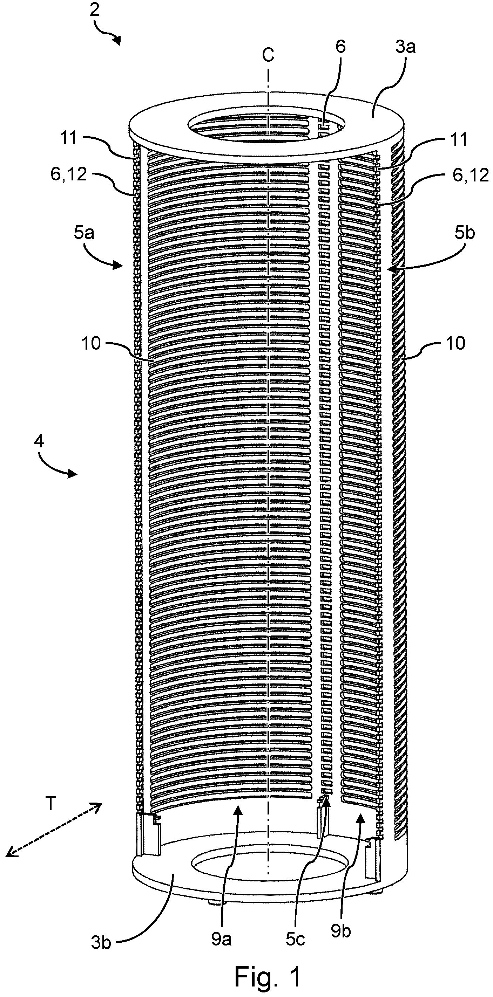

In embodiments, the shell 4 has a uniform thickness apart from the slots 6 and the gas transmission openings 10. In this way, construction of the shell may be relatively simple. It shall be appreciated, e.g. in view of Fig. 1, that nevertheless elements of the carrier 6 may extend radially inwardly from the shell 4, e.g. where the shell 4 connects with the end members 3a, 3b.

In embodiments, the system 1 is configured so that the engaged holder rings 7 are spaced apart from the shell 4 except at the ring support slots 6. Relatively uniform movement of gas to the wafer 8 can thereby be promoted.

In embodiments, the shell 4 is connected to the first end member 3a and the second end member 4a at respective outer edges of the first end member 3a and the second end member 3b to form a cylindrical wall section of the carrier 2. In this way, the shape of the shell 4 may essentially follow circular edges of the wafers 8, so that the shell 4 can be radially spaced apart from the wafer 8 in a manner that is substantially uniform with respect to the circumferential direction. Nevertheless, as explained elsewhere herein, the shell 4 preferably does not extend along the complete circumference of the wafer 8 so that holder rings 7 and wafers 8 can be moved into and out from the carrier 2 in a transverse direction T relatively easily.

In embodiments, each of the holder rings 7 has ring projections 14 projecting from the annular body. In embodiments, the ring projections 14 are arranged to be in contact with the wafer 8 and to space the wafer 8 apart from the annular body 13 when the wafer 8 is supported by the holder ring 7 in the carrier 2.

Such ring projections may advantageously obviate the need for the wafers to be in direct contact with the carrier, which could otherwise contribute to non-uniformities. Meanwhile, by spacing the wafer apart from the annular body, the ring projections allow an end effector of a wafer positioning robot to reach under the supported wafer without interference from the annular body.

In embodiments, at the ring projections 14, an inner radius RI of the annular body 13 is locally enlarged, in particular being large compared to a circumferential average or median of the inner radius RI of the annular body 13. In this way, a local adverse uniformity effect from the presence of the ring projections 14 may be at least partly compensated by a locally reduced surface area of the annular body 13.

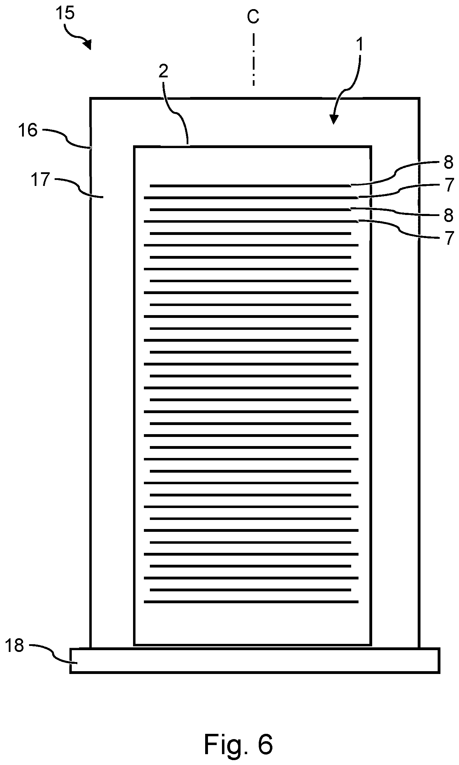

Fig. 6 illustrates a possible combination of a wafer boat system 1 as described herein and an apparatus 15 constructed and arranged to process a plurality of substrates, in particular wafers 8. The apparatus 15 may be of a type known as such and comprises: a process tube 16 creating a process chamber 17; and a door 18 configured to close off the process chamber 17 while supporting the wafer boat system 1 with a plurality of substrates, in particular wafers 8, therein.

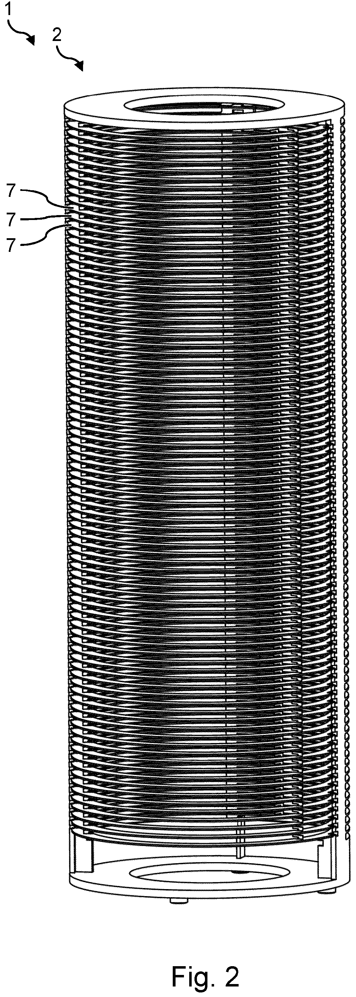

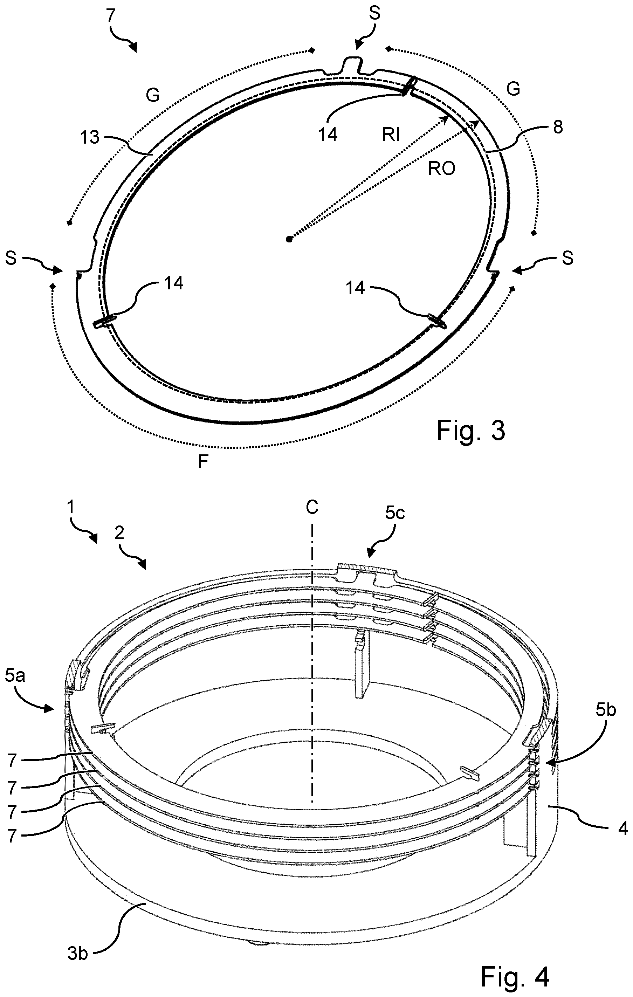

In Fig. 6, for clarity of the drawing, the wafer boat system 1 is shown highly schematically, e.g., not showing engagements between carrier 2, holder rings 7 and wafers 8, wherein it shall be appreciated that the wafer system 1 in Fig. 6 may be configured essentially as shown in Figs. 1 to 5, as one example.

Although the invention has been described herein using examples of embodiments and drawings, these do not limit the scope of the invention as determined by the claims. Within said scope, many variations, combinations and extensions are possible, as shall be apparent to the skilled person having the benefit of the present disclosure.

### LIST OF REFERENCE SIGNS

- 1.: Wafer boat system
- 2.: Carrier
- 3a.: First end member
- 3b.: Second end member
- 4.: Shell
- 5a.: Outer axial series of ring support slots
- 5b.: Outer axial series of ring support slots
- 5c.: Inner axial series of ring support slots
- 6.: Ring support slot
- 7.: Holder ring
- 8.: Wafer
- 9a.: Axial series of gas transmission openings
- 9b.: Axial series of gas transmission openings
- 10.: Gas transmission opening
- 11.: Tooth
- 12.: Interdental space
- 13.: Annular body
- 14.: Ring projection
- 15.: Apparatus
- 16.: Process tube
- 17.: Process chamber
- 18.: Door
- C.: Carrier axis
- F.: Circumferential positions not radially adjacent shell
- G.: Circumferential positions corresponding to gas transmission openings
- RI.: Inner radius
- RO.: Outer radius
- ROmax.: Largest outer radius
- ROmin.: Smallest outer radius
- S.: Circumferential positions corresponding to ring support slots
- T.: Transverse direction

## Claims

1. A wafer boat system comprising:
- a carrier extending along a carrier axis and comprising a first end member at a first axial end of the carrier, a second end member at a second axial end of the carrier, and a shell connecting the first end member with the second end member, wherein at least three circumferentially spaced apart axial series of ring support slots are provided to the shell, the ring support slots defining axially spaced apart holder ring positions; and
- a plurality of holder rings each engageable with the ring support slots to position the holder ring in the carrier at one of the holder ring positions, wherein the holder ring is configured to support a wafer in the carrier,
wherein the shell circumferentially interconnects the axial series of slots, wherein axial series of gas transmission openings are formed in the shell between the axial series of slots.

2. The wafer boat system according to claim 1, wherein the shell is circumferentially bound at two outer ones of the axial series of slots to allow holder rings and wafers to be moved into or out from the carrier between the two outer axial series of slots in a transverse direction with respect to the carrier.

3. The wafer boat system according to claim 2, wherein the two outer axial series of slots are formed as toothed edges of the shell, each toothed edge having an axial series of teeth with interdental spaces between the teeth, wherein the interdental spaces form the respective slots.

4. The wafer boat system according to any of the preceding claims, wherein an outer radius of the holder ring varies along its circumference between a largest outer radius and a smallest outer radius, wherein the outer radius is smaller than the largest outer radius, and preferably larger than the smallest outer radius, at circumferential positions corresponding to the gas transmission openings when the holder ring is engaged with the ring support slots.

5. The wafer boat system according to claim 4 as dependent from claim 2, wherein the outer radius is larger than the smallest outer radius, and preferably smaller than or equal to the largest outer radius, at circumferential positions that are not radially adjacent the shell when the holder ring is engaged with the ring support slots.

6. The wafer boat system according to claim 5 as dependent from claim 4, wherein the outer radius at the circumferential positions that are not radially adjacent the shell is larger than the outer radius at the circumferential positions corresponding to the gas transmission openings.

7. The wafer boat system according to any of claims 4-6, wherein the smallest outer radius is present adjacent circumferential positions corresponding to one or more of the ring support slots, in particular at circumferential positions that are circumferentially between one or more of the ring support slots and adjacent ones of the gas transmission openings.

8. The wafer boat system according to any of the preceding claims, wherein the gas transmission openings are arranged axially between the holder ring positions.

9. The wafer boat system according to any of the preceding claims, wherein the shell has a uniform thickness apart from the slots and the gas transmission openings.

10. The wafer boat system according to any of the preceding claims, configured so that the engaged holder rings are spaced apart from the shell except at the ring support slots.

11. The wafer boat system according to any of the preceding claims, wherein the shell is connected to the first end member and the second end member at respective outer edges of the first end member and the second end member to form a cylindrical wall section of the carrier.

12. The wafer boat system according to any of the preceding claims, wherein each of the holder rings has an annular body and ring projections projecting from said annular body, the ring projections being arranged to be in contact with the wafer and to space the wafer apart from the annular body when the wafer is supported by the holder ring in the carrier,
wherein, at the ring projections, an inner radius of the annular body is locally enlarged, in particular being large compared to a circumferential average or median of the inner radius of the annular body.

13. A carrier evidently configured for use as the carrier of a wafer boat system according to any of the preceding claims.

14. A holder ring evidently configured for use as one of the holder rings of a wafer boat system according to any of the claims 1 - 12.

15. Combination of a wafer boat system according to any of claims 1-12 and an apparatus constructed and arranged to process a plurality of substrates, the apparatus comprising:
- a process tube creating a process chamber; and
- a door configured to close off the process chamber while supporting the wafer boat system with a plurality of substrates therein.
